# EUROPEAN PATENT APPLICATION

(11) **EP 4 730 334 A1**
(43) Date of publication of application: **22.04.2026**
(21) Application number: 25206835.8
(22) Date of filing: 06.10.2025
(51) Int. Cl.: G11C 11/406, G11C 11/408

(54) **SYSTEM AND METHODS FOR ROW-HAMMER MITIGATION**

(30) Priority: 17.10.2024 US 202463708623 P; 31.01.2025 US 202519043238
(71) Applicant: Samsung Electronics Co., Ltd., Suwon-si, Gyeonggi-do 16677 (KR)
(72) Inventor: LI, Zongwang, San Jose, CA, 95134 (US); PITCHUMANI, Rekha, San Jose, CA, 95134 (US); KI, Yang Seok, San Jose, CA, 95134 (US)
(74) Representative: Kuhnen & Wacker Patent- und Rechtsanwaltsbüro PartG mbB

(57) **Abstract**

A device comprising a processor and a memory, wherein the memory stores instructions that, when executed by the processor, cause the processor to receive a first request associated with a first row of a memory device, identify a second row associated with the first row, identify a first counter value associated with the second row, determine that the first counter value satisfies a threshold value, and issue a refresh request for the second row based on the first counter value satisfying the threshold value.

## Description

### FIELD

One or more aspects of embodiments according to the present disclosure relate to memory devices, and more particularly to mitigating attacks on dynamic random-access memory (DRAM) memory devices.

### BACKGROUND

Dynamic Random-Access Memory (DRAM) is a type of volatile memory commonly used in computers and other electronic devices. DRAM memory cells, when accessed, may leak charge. The leaked charge can potentially affect nearby memory rows that were not addressed in the original memory access.

The above information disclosed in this Background section is only for enhancement of understanding of the background of the present disclosure, and therefore, it may contain information that does not form prior art.

### SUMMARY

In one or more embodiments, a method comprises receiving a first request associated with a first row of a memory device; identifying a second row associated with the first row; identifying a first counter value associated with the second row; determining that the first counter value satisfies a threshold value; and issuing a refresh request for the second row based on the first counter value satisfying the threshold value.

In some embodiments, the method further comprises changing a status of an item associated with the first row based on issuing the refresh request.

In some embodiments, the first counter value is stored in a first cache line of a cache, wherein the first cache line is associated with the second row.

In some embodiments, the cache includes a set of cache lines storing counter values associated with a set of rows of the memory device, wherein the cache lines in the set are represented in a tree structure wherein a parent node represents a cache line storing a higher counter value than a cache line of a child node.

In some embodiments, the method further comprises receiving a second request associated with a third row of the memory device; identifying a fourth row associated with the third row; identifying a second counter value associated with the fourth row; determining that the second counter value is below the threshold value; and incrementing the second counter value.

In some embodiments, the method further comprises receiving a second request associated with a third row of the memory device; identifying a fourth row associated with the third row; determining, based on a set of items in a cache, that the fourth row is associated with a second counter value; determining the set of items in the cache is below a threshold number of items; adding, to the set of items, an item representing the fourth row; and setting a counter value associated with the fourth row to an initial value.

In some embodiments, the method further comprises receiving a second request associated with a third row of the memory device; identifying a fourth row associated with the third row; determining, based on a set of items in a cache, the fourth row is associated with a second counter value; determining the set of items in the cache satisfies a threshold number of items; determining, based on a set of counters associated with the set of items, that a counter in the set of counters is larger in value than the second counter value; and incrementing the second counter value.

In some embodiments, the method further comprises receiving a second request associated with a third row of the memory device; identifying a fourth row associated with the third row; determining, based on a set of items in a cache, that the fourth row is associated with a second counter; determining that the set of items in the cache satisfies a threshold number of items; determining, based on a set of counters associated with the set of items, that a counter in the set of counters is larger in value than the second counter; changing a status of an item associated with the counter; adding, to the set of items, an item representing the fourth row; and setting a third counter associated with the fourth row to an initial value.

In some embodiments, the method further comprises issuing a refresh request for a row of the memory device associated with the item associated with the counter.

In some embodiments, the second row is adjacent to the first row.

In one or more embodiments, a device comprises a processor; and a memory, wherein the memory stores instructions that, when executed by the processor, cause the processor to: receive a first request associated with a first row of a memory device; identify a second row associated with the first row; identify a first counter value associated with the second row; determine that the first counter value satisfies a threshold value; and issue a refresh request for the second row based on the first counter value satisfying the threshold value.

In some embodiments, the instructions, when executed by the processor, further cause the processor to: receive a second request associated with a third row of the memory device; identify a fourth row associated with the third row; identify a second counter value associated with the fourth row; determine that the second counter value is below the threshold value; and increment the second counter value.

In some embodiments, the instructions, when executed by the processor, further cause the processor to: receive a second request associated with a third row of the memory device; identify a fourth row associated with the third row; determine, based on a set of items in a cache, that the fourth row is associated with a second counter value; determine the set of items in the cache is below a threshold number of items; add, to the set of items, an item representing the fourth row; and setting a counter value associated with the fourth row to an initial value.

In some embodiments, the instructions, when executed by the processor, further cause the processor to: receive a second request associated with a third row of the memory device; identify a fourth row associated with the third row; determine, based on a set of items in a cache, the fourth row is associated with a second counter value; determine the set of items in the cache satisfies a threshold number of items; determine, based on a set of counters associated with the set of items, that a counter in the set of counters is larger in value than the second counter value; and increment the second counter value.

In some embodiments, the instructions, when executed by the processor, further cause the processor to: receive a second request associated with a third row of the memory device; identify a fourth row associated with the third row; determine, based on a set of items in a cache, that the fourth row is associated with a second counter; determine that the set of items in the cache satisfies a threshold number of items; determine, based on a set of counters associated with the set of items, that a counter in the set of counters is larger in value than the second counter; change a status of an item associated with the counter; add, to the set of items, an item representing the fourth row; and set a third counter associated with the fourth row to an initial value.

In one or more embodiments, a device comprises a processor; and a memory, wherein the memory stores instructions that, when executed by the processor, cause the processor to: detect activation of a first row of a memory device; identify a second row associated with the first row; identify a first counter value associated with the second row; determine that the first counter value satisfies a threshold value; and refresh the second row based on the first counter value satisfying the threshold value.

In some embodiments, the instructions, when executed by the processor, further cause the processor to: detect activation of a third row of the memory device; identify a fourth row associated with the third row; identify a second counter value associated with the fourth row; determine that the second counter value is below the threshold value; and increment the second counter value.

In some embodiments, the instructions, when executed by the processor, further cause the processor to: detect activation of a third row of the memory device; identify a fourth row associated with the third row; determine, based on a set of items in a cache, that the fourth row is associated with a second counter value; determine the set of items in the cache is below a threshold number of items; add, to the set of items, an item representing the fourth row; and set a counter value associated with the fourth row to an initial value.

In some embodiments, the instructions, when executed by the processor, further cause the processor to: detect activation of a third row of the memory device; identify a fourth row associated with the third row; determine, based on a set of items in a cache, the fourth row is associated with a second counter value; determine the set of items in the cache satisfies a threshold number of items; determine, based on a set of counters associated with the set of items, that a counter in the set of counters is larger in value than the second counter value; and increment the second counter value.

In some embodiments, the instructions, when executed by the processor, further cause the processor to: detect activation of a third row of the memory device; identify a fourth row associated with the third row; determine, based on a set of items in a cache, that the fourth row is associated with a second counter; determine that the set of items in the cache satisfies a threshold number of items; determine, based on a set of counters associated with the set of items, that a counter in the set of counters is larger in value than the second counter; change a status of an item associated with the counter; add, to the set of items, an item representing the fourth row; and set a third counter associated with the fourth row to an initial value.

These and other features, aspects and advantages of the embodiments of the present disclosure will be more fully understood when considered with respect to the following detailed description, appended claims, and accompanying drawings. The actual scope of the invention is defined by the appended claims.

### BRIEF DESCRIPTION OF THE DRAWINGS

Non-limiting and non-exhaustive embodiments of the present embodiments are described with reference to the following figures, wherein like reference numerals refer to like parts throughout the various views unless otherwise specified.
Fig. 1 depicts a block diagram of a system with row hammer mitigation, according to one or more embodiments;
Fig. 2 depicts a conceptual diagram of memory rows in a memory device, according to one or more embodiments;
Fig. 3 depicts a block diagram of a mitigation engine, according to one or more embodiments;
Fig. 4 depicts a conceptual diagram of a portion of a least frequently used (LFU) cache, according to one or more embodiments;
Fig. 5 depicts a flow diagram of a process for preventatively refreshing a memory row, according to one or more embodiments; and
Fig. 6 depicts a flow diagram of a process for mitigating effects of row hammer attacks, according to one or more embodiments.

### DETAILED DESCRIPTION

Hereinafter, example embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, descriptions thereof may not be repeated. Further, in the drawings, the relative sizes of elements, layers, and regions may be exaggerated and/or simplified for clarity.

Embodiments of the present disclosure are described below with reference to block diagrams and flow diagrams. Thus, it should be understood that each block of the block diagrams and flow diagrams may be implemented in the form of a computer program product, an entirely hardware embodiment, a combination of hardware and computer program products, and/or apparatus, systems, computing devices, computing entities, and/or the like carrying out instructions, operations, steps, and similar words used interchangeably (for example the executable instructions, instructions for execution, program code, and/or the like) on a computer-readable storage medium for execution. For example, retrieval, loading, and execution of code may be performed sequentially such that one instruction is retrieved, loaded, and executed at a time. In some example embodiments, retrieval, loading, and/or execution may be performed in parallel such that multiple instructions are retrieved, loaded, and/or executed together. Thus, such embodiments can produce specifically-configured machines performing the steps or operations specified in the block diagrams and flow diagrams. Accordingly, the block diagrams and flow diagrams support various combinations of embodiments for performing the specified instructions, operations, or steps.

In addition, a feature of embodiments of the present disclosure may be combined or combined with one or more other features, partially or entirely, and may be operated in various ways, and an embodiment may be implemented independently of one or more other embodiments, or in conjunction with the one or more other embodiments.

DRAM devices may be susceptible to row-hammer attacks, in which a specific row in a DRAM device is repeatedly accessed (or "hammered") in a short amount of time. DRAM memory cells, when accessed, may leak charge. When a specific row is repeatedly accessed in a short amount of time, the leaked charge may accumulate and induce electrical interference in neighboring rows. This may cause bit flips to occur in the memory cells of the neighboring rows, which can lead to data corruption, data exposure, malicious code injection, or other data integrity and security vulnerabilities. As memory cells in DRAM devices become increasingly dense, the electrical interference caused by row-hammer attacks may affect more and more neighboring rows.

One or more embodiments of the present disclosure provides systems, devices, and methods that aim to mitigate the effects of row-hammer attacks by preventatively refreshing rows that may become vulnerable to bit flips. In some embodiments, when a particular memory row is activated (e.g., is subject to a write command), a counter is incremented for one or more neighbor memory rows of the activated row. When the counter of a particular row reaches a threshold count, the row is preventatively refreshed to help mitigate the occurrence of a bit flip. A neighbor row of an activated row may also be referred to herein as an affected row.

In some embodiments, a designated or set number of rows are tracked using respective counters. In some embodiments, the rows that are tracked using the counters may be selected based on the row satisfying a certain ranking position with respect to frequency of being affected. The tracked rows may be selected using a frequency-based technique, such as, for example, a Misra-Gries selection technique or Count-Min Sketch, etc. The number of rows that are tracked may be based on specifications of the memory device, such as a refresh window, row-hammer threshold, number of neighbor rows affected, among others.

In some embodiments, a least frequently used (LFU) caching technique is used to store the data for tracking the designated number of rows and the respective number of times an individual row has been affected by an activation. For example, an LFU cache may store a representation of a row (e.g., a row ID) and the corresponding counter value for the individual row, in which the counter value represents the number of times the individual row has been affected by an activation.

In some embodiments, activations affecting rows that are not a part of the rows tracked in the LFU cache are tracked using a counter (referred to as a spillover counter). The spillover counter may be incremented based on detecting that a row that is not tracked in the LFU cache is affected by an activation. In some embodiments, a counter value may be selected from the counter values of the tracked rows based on the counter value satisfying a condition (e.g., having the smallest value). For example, the counter values of the tracked rows may be ranked based on value. A counter value having a certain ranking position (e.g., lowest value) may be selected and compared to the spillover counter value. In some embodiments, when the spillover counter value is at least as large as the selected counter value corresponding to a row tracked in in the LFU cache, the entry in the LFU cache associated with a selected counter value is removed or evicted from the LFU cache, and an entry representing a row not tracked in the LFU cache is added to the LFU cache. In some embodiments, when an entry row is evicted from the LFU cache, the corresponding DRAM row is preventatively refreshed.

The techniques according to one or more embodiments of the present disclosure can help prevent or minimize bit flips from occurring in memory cells by refreshing memory rows before a row becomes vulnerable due to electrical interference caused by repeated activation of neighboring rows. In some embodiments, DRAM memory cells can be protected from row-hammer attacks without significant performance degradation that may otherwise occur if preventative refresh cycles occur too frequently.

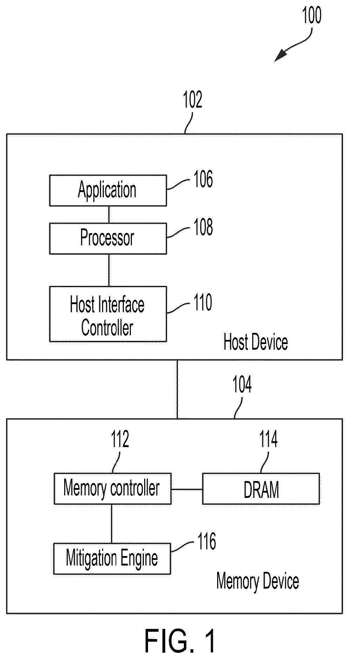

Fig. 1 depicts a block diagram of a system 100 with row hammer mitigation, in accordance with one or more embodiments. The system may include a host computing device ("host") 102 and a memory device 104. In some embodiments, data communication links coupling various components of the host 102 and/or the memory device 104 may include various general-purpose interfaces such as, for example, Ethernet, Universal Serial Bus (USB), and/or any wired or wireless data communication link.

The host 102 may include a processor 108 and a host interface controller 110. The processor 108 may include one or more central processing unit (CPU) cores configured to run one or more applications 106 based on computer program instructions stored in the host 102, the memory device 104, elsewhere in the system 100, or obtained via one or more communication links. The application 106 may be any application configured to transmit commands (e.g., write commands) that activate memory cells of the memory device 104. For example, the application 106 may be a big data analysis application, e-commerce application, database application, machine learning application, and/or the like.

The host interface controller 110 may include physical connections as well as software instructions which may be executed by the processor 108. In some embodiments, the host interface controller 110 allows the host 102 and the memory device 104 to send and receive data using a protocol such as, for example, a computer express link (CXL), although embodiments are not limited thereto. In addition or in lieu of CXL, the host interface controller 110 may use other protocols such as Cache Coherent Interconnect for Accelerators (CCIX), dual in-line memory module (DIMM) interface, Small Computer System Interface (SCSI), Non Volatile Memory Express (NVMe), Peripheral Component Interconnect Express (PCIe), remote direct memory access (RDMA) over Ethernet, Serial Advanced Technology Attachment (SATA), Fiber Channel, Serial Attached SCSI (SAS), NVMe over Fabric (NVMe-oF), iWARP protocol, InfiniBand protocol, 5G wireless protocol, Wi-Fi protocol, Bluetooth protocol, and/or the like.

In some embodiments, the memory device 104 includes a memory controller 112 and a DRAM 114. In some embodiments the memory device 104 is configured to present a memory space accessible to the host 102 using memory load/store commands. Although the present disclosure uses DRAM as an example storage type, the present disclosure is not limited thereto.

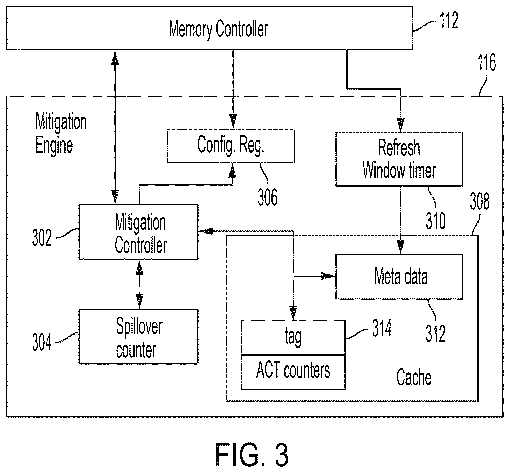

The memory device 104 may further include a mitigation engine 116. In some embodiments, the mitigation engine 116 is implemented as a part of the memory controller 112. In some embodiments, the mitigation engine 116 is configured to provide row hammer mitigation for the DRAM 114. In some embodiments, the mitigation engine 116 tracks row activations and preventatively refreshes rows that may become vulnerable to bit flips, as described further below with reference to Fig. 3.

The memory controller 112 may be connected to the DRAM 114 over one or more storage interfaces. The memory controller 112 may receive data commands from the host 102, and execute such commands with respect to the DRAM 114. In this regard, the memory controller 112 may include at least one processing component embedded thereon for interfacing with the host 102, the DRAM 114, and the mitigation engine 116. The processing component may include, for example, a digital circuit (e.g., a microcontroller, a microprocessor, a digital signal processor, or a logic device (e.g., a field programmable gate array (FPGA), an application-specific integrated circuit (ASIC), and/or the like)) capable of executing data access instructions (e.g., via firmware and/or software) to provide access to and from the data stored in the DRAM 114 according to the data access instructions.

In some embodiments, the memory device 104 receives a request from the host device 102 to activate a memory cell of the DRAM 114, such as a write request. The request may be initiated by the application 106 through the processor 108. The memory controller 112 facilitates access to the DRAM 114 accordingly. In some embodiments, the memory controller 112 also sends a request to the mitigation engine 116, triggering a row hammer mitigation process.

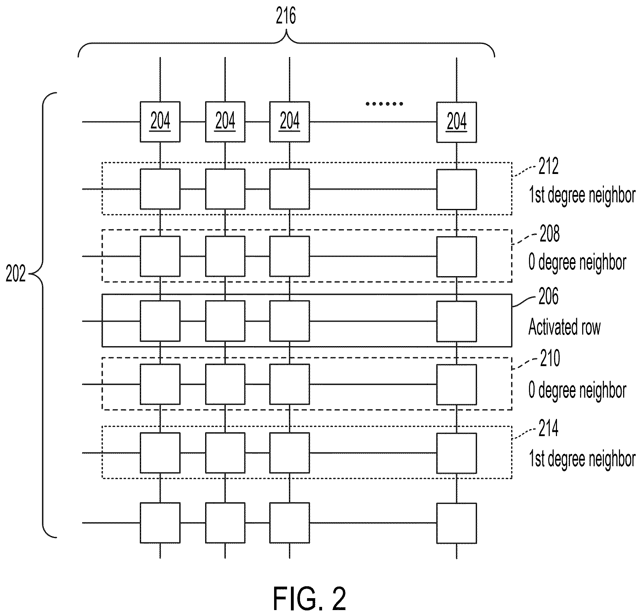

Fig. 2 depicts a conceptual representation of a plurality of rows 202 of the DRAM 114, in accordance with example embodiments. The DRAM 114 may include a plurality of memory cells 204 organized into the plurality of rows 202 and a plurality of columns 216. A memory cell 204 may be addressed based on the row 202 and column 216 to which it belongs. Data in a memory cell 204 is stored as charge in corresponding capacitors. As charge may leak from the capacitors over time, a memory cell 204 may be refreshed periodically to maintain the integrity of the stored data. This may be done by recharging the capacitors associated with the memory cells 204. For example, a refresh operation may include reading or rewriting the data in a memory cell 204 so that the memory cell 204 retains the correct values and the associated capacitors have sufficient charge. Memory cells 204 may be refreshed according to a default refresh frequency or schedule.

When data is written to a memory cell 204, the row 202 to which the memory cell 204 belongs is activated. In the illustrated example, row 206 represents a row 202 that has been activated and may be referred to as an activated row 206. When a specific row 202 is repeatedly activated in a short amount of time (such as during a row hammer attack), neighboring rows (e.g., rows 208, 210, 212, 214) may experience exacerbated charge leakage or other electrical interference at a faster rate than the default refresh frequency. A neighbor row (e.g., rows 208, 210, 212, 214) of an activated row may also be referred to herein as an affected row. The affected rows may become vulnerable to bit flip or other data corruption before the next scheduled refresh.

In the illustrated example, row 208 and row 210 are neighbor rows of activated row 206. Specifically, neighbor row 208 and neighbor row 210 are 0 degree neighbors of row 206, signifying that rows 208 and 210 are adjacent to activated row 206. Neighbor row 212 and neighbor row 214 are 1^{st} degree neighbors of activated row 206, signifying that there is one row 202 between neighbor row 212 and activated row 206, and one row 202 between row 214 and activated row 206. Rows 202 further away from the activated row 206 may be considered 2^{nd} degree neighbors, 3^{rd} degree neighbors, and so forth. In some embodiments, a neighbor row may refer to any row within *n* degrees of the activated row 206 that may be affected by activation of the activated row 206, in which *n* may be based on the specifications and tolerances of the DRAM 114. In one embodiment, the 0 degree neighbors are affected and considered to be neighbor rows. In some embodiments, both 0 degree neighbors and 1^{st} degree neighbors are affected and considered to be neighbor rows. In some embodiments, in DRAMs with denser rows 202, more rows may be affected and considered neighbor rows than in DRAMs with lower density.

One or more embodiments of the present disclosure provides systems, devices, and methods that aim to mitigate the effects of row-hammer attacks by preventatively refreshing neighboring (i.e., affected) rows that may become vulnerable to bit flips.

Fig. 3 depicts a block diagram of the mitigation engine 116, in accordance with example embodiments. In some embodiments, the mitigation engine 116 is implemented external to the memory controller 112 and communicates with the memory controller over a communication interface. In some embodiments, the mitigation engine 116 is implemented within or as a part of the memory controller 112. The memory controller 112 may be configured to provide information regarding DRAM activation requests, address mapping configurations, and refresh window information to the mitigation engine 116. In some embodiments, the mitigation engine 116 includes a configuration register 306, which sets up various parameters used by the mitigation engine 116, such as row hammer threshold, cache line size, among others.

In some embodiments, the mitigation engine 116 keeps track of the frequently affected rows 202 in the DRAM 114 and the number of times these rows are affected. The mitigation engine 116 may issue requests for the memory controller 112 to preventatively refresh a row 202 based on various detected conditions. In some embodiments, the mitigation engine 116 may include or have access to a cache 308 storing data used for tracking the frequently affected rows 202. The cache may be implemented using a relatively small memory such as, for example, a static random access memory (SRAM) that provides an efficient and low-complexity solution for storing the tracked data.

In some embodiments, the cache 308 stores information for a designated number of frequently affected rows that are tracked in the cache 308. The designated number of frequently affected rows that are tracked in the cache 308 may be based on specifications and/or selected tolerances of the memory device 104 and/or DRAM 114.

In some embodiments, the designated number of frequently affected rows may be determined based on a row hammer threshold and a number (e.g., a maximum or threshold number) of activations that can be tolerated between refreshes (e.g., a refresh window), among other factors. A row hammer threshold refers to the number of times a row can be affected by an activation of a neighboring row before the affected row becomes vulnerable. For example, the designated number "K" of frequently affected rows to be tracked in the cache 308 may be based on the condition of K>WR/T-1, wherein "W" is a threshold (e.g., maximum) number of activations that can be tolerated within the refresh window, "T" is the row hammer threshold value, and "R" is the number of neighboring rows that, when activated, can cause a particular row to be affected. For example, referring to Fig. 2, row 206 may be affected by the activation of rows 208, 210, 212, or 214. In this example, the "R" value may be 4.

The mitigation engine 116 may include a mitigation controller 302. In some embodiments, the mitigation controller 302 uses a Misra-Gries selection technique to select the rows 202 to be tracked using the cache 308. The selection of rows using the Misra-Gries technique may be based on how frequently the rows 202 are affected by neighboring activations. The mitigation controller 302 may update the cache 308 accordingly.

In some embodiments, the cache 308 utilizes a least frequently used (LFU) caching technique to store the row tracking data 314 for tracking the designated number of frequently affected rows and the respective number of times an individual row 202 has been affected by an activation. In some embodiments, the cache 308 includes metadata 312 to facilitate efficient access to the tracking data 314.

In some embodiments, the mitigation engine 116 includes a spillover counter 304 which keeps track of the number of times an activation affects a row that is not tracked in the cache 308 as one of the predefined number of frequently affected rows.

In some embodiments, the mitigation engine 116 includes a refresh window timer 310 which informs when certain DRAM rows 202 are refreshed. In some embodiments, when a row 202 is refreshed, a corresponding valid bit in the metadata 312 for the cache line associated with the row 202 is reset by the refresh window timer 310 at the end of a refresh window.

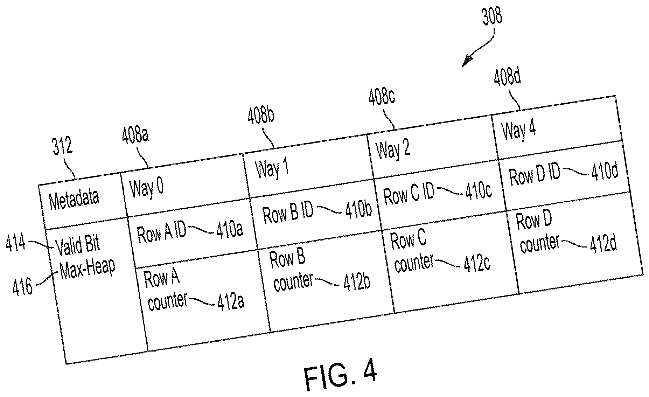

Fig. 4 depicts a conceptual diagram of a portion of the cache 308, in accordance with example embodiments. In some embodiments, the cache 308 may utilize a set-associative scheme, as illustrated. The example of Fig. 4 depicts a 4-way set-associative cache, in which a set of cache lines includes four ways 408a, 408b, 408c, 408d which store tracking data for individual rows 202 of the DRAM 114. The set-associative cache is not limited to the 4-way example shown and may include any *n-*way set-associative cache.

In some embodiments, a tag includes a row identifier 410a, 410b, 410c, 410d (collectively referenced as 410) associated with an individual row 202 of the DRAM 114, and a data value corresponding to the tag includes a counter value 412a, 412b, 412c, 412d (collectively referenced as 412) for the row 202. The counter value 412 represents the number of times the row 202 has been affected by an activation of a neighboring row. In some embodiments, the row identifier 410 is a selected bit group of the corresponding row's DRAM row address.

When a particular memory row 206 is activated (e.g., is subject to a write command), the respective counter value 412 of one or more of the neighbor rows (e.g., rows 208, 210) that are tracked in the cache 308 is incremented. When the counter value 412 of a particular row reaches a threshold value, the row (e.g., rows 208, 210) is preventatively refreshed to help mitigate the occurrence of a bit flip. In some embodiments, the threshold value is based on the row hammer threshold and/or other specifications and/or tolerances of the memory device 104 and/or DRAM 114. The counter value 412 may be incremented by any value (e.g., 1, 2, .5, 10, -1, -2).

In some embodiments, the counter may be implemented using techniques other than numerical values to keep track of the number of times a row 202 has been affected by an activation, and incrementing the counter can include any change in status of the counter. Correspondingly, the threshold value may be implemented numerically or otherwise.

In some embodiments, the cache 308 includes metadata 312 associated with a set of ways or cache lines. In some embodiments, the metadata 312 of a set includes a respective valid bit 414 for the ways or cache lines. The metadata 312 may also include a max-heap representation 416 of the ways or cache lines. In some embodiments, the ways or cache lines associated with the max-heap representation are represented as nodes in a tree structure in which the hierarchy of the nodes is based on the counter values 412. For example, a parent node in the max-heap 416 has a higher counter value than a child node. The max-heap representation 416 of the ways or cache lines provides an efficient way to identify the ways (and associated rows) in the set with relatively smaller counter values.

The mitigation engine 116 includes a refresh window timer 310 which informs when certain DRAM rows 202 are refreshed. In some embodiments, when a row 202 is refreshed, the corresponding valid bit 414 in the metadata 312 for the cache line associated with the row is reset by the refresh window timer 310 at the end of a refresh window. In this regard, the valid bit 414 provides an indication of whether the data stored in the corresponding cache line is valid or not, or if the cache line is empty. For example, the valid bit may be set to 1 if the cache line includes valid data, and set to 0 if the cache line is empty or if the data in in the cache line does not satisfy one or more validity conditions.

In some embodiments, when the memory controller 112 receives an activation request to activate a memory cell 204 in the DRAM 114 (or otherwise detects an activation), such as from an application 106 on the host device 102, the memory controller 112 triggers a row hammer mitigation process. In some embodiments, the row hammer mitigation process may include generating a request to the mitigation controller 302 of the mitigation engine 116. The mitigation controller 302 may check the metadata 312 of the cache 308 and the row identifiers to determine whether a row 202 affected by the activation is tracked in the cache 308. If the row 202 is tracked in the cache 308, the mitigation controller 302 checks whether the corresponding counter value (e.g., counter value 412a) satisfies (e.g., is at least as large as) a threshold value.

If the counter value does satisfy the threshold value, a preventative refresh request is issued to the memory controller 112 and the corresponding valid bit is reset. If the counter value does not satisfy the threshold value, the counter value is incremented. In some embodiments, the threshold value is based on the row hammer threshold and/or other specifications and/or tolerances of the memory device 104 and/or DRAM 114.

In some embodiments, if the affected row is not tracked in the cache, the mitigation controller 302 checks if the number of rows tracked in the cache satisfies the predefined number of rows to be tracked in the cache (e.g., whether the cache is full). If the number of rows being tracked is lower than the predefined number, the tag (e.g., row identifier) for the affected row is added to the cache, a corresponding counter value is set to an initial value, such as 0 or 1, and a corresponding valid bit is enabled.

If the affected row is not tracked in the cache, and the number of rows tracked in the cache satisfies the predefined number of rows to be tracked in the cache (e.g., the cache is full), the mitigation controller 302 checks the value of a spillover counter 304. The spillover counter 304 may be stored in the cache 308 or external to the cache 308. In some embodiments, the spillover counter 304 keeps track of the number of times an activation affects a row that is not tracked in the cache 308 as one of the predefined number of frequently affected rows. In some embodiments, a counter value 412 may be selected from the counter values 412 of the tracked rows based on the counter value satisfying a condition (e.g., having the smallest value). In some embodiments, the mitigation controller 302 compares the selected counter value from the counter values 412 of the tracked rows to the value of the spillover counter 304. If value of the spillover counter 304 is at least as large as the selected counter value, the mitigation controller 302 may evict the way or cache line with the selected counter value. The mitigation controller 302 may add a tag (e.g., a row identifier) for the affected row to the cache to replace to evicted row, set a corresponding counter value to an initial value, and enable a corresponding valid bit.

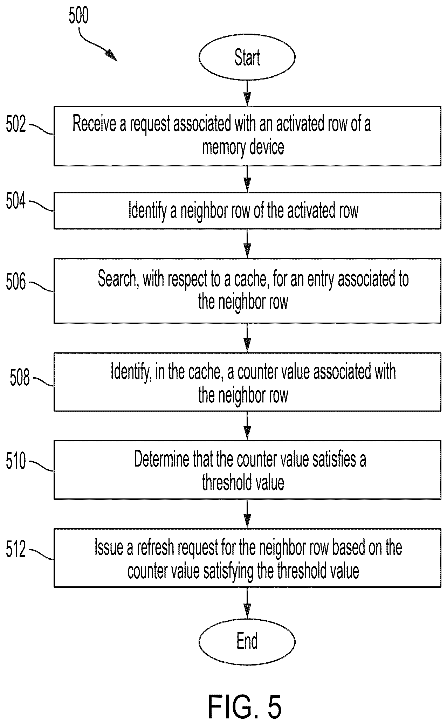

Fig. 5 depicts a flow diagram of a process 500 of preventatively refreshing a memory row of a DRAM 114 for row hammer mitigation, in accordance with example embodiments. In some embodiments, the mitigation engine 116 may be a part of the memory controller 112. In some embodiments, the mitigation engine 116 may be distinct from the memory controller 112. In some embodiments, any steps or actions said to performed by the mitigation engine 116 may be performed by the memory controller 112, and any steps or actions said to performed by the memory controller 112 may be performed by the mitigation engine 116.

The process starts, and at step 502, the row hammer mitigation engine 116 receives a request from the memory controller 112 of the memory device 102. In some embodiments, the request is triggered based on detecting an activation (e.g., write action) of memory cell 204 in a row 202 of the DRAM 114, such as, for example, activated row 206. In some embodiments, the request includes a row identifier identifying the activated row 206. In some embodiments, the request includes a row identifier identifying a neighbor row of the activated row.

At step 504, the row hammer mitigation engine 116 identifies a neighbor row (e.g., row 208) of the activated row 206 and the row identifier (e.g., identifier 410a) associated with the neighbor row 208. For example, as depicted with respect to Fig. 2, there may be one or more neighbor rows (e.g., neighbor rows 208, 210, 212, 214) that are affected by the activation of row 206. In some embodiments, the neighbor row is a row adjacent to the activated row, also referred to as a 0 degree neighbor (e.g., neighbor rows 208, 210). The number rows that are considered to be neighbor rows (e.g., the affected rows) may be predefined and based on the specifications and tolerances of the DRAM 114. In some embodiments, the mitigation engine 116 determines the neighbor row 208 based on the identifier of the activated row provided in the request, and a table or mapping of the rows 202 of the DRAM 114. In some embodiments, the memory controller 112 identifies a neighbor row and provides the row identifier of the neighbor row to the mitigation engine in the request, and the mitigation engine 116 identifies the neighbor row based on the information in the request.

At step 506, the row hammer mitigation engine 116 accesses the cache 308 and searches for data corresponding to the identified neighbor row 208 based on the row identifier 410a of the neighbor row 208. In some embodiments, the mitigation engine 116 queries the metadata 312 associated with the cache 308.

At step 508, the row hammer mitigation engine 116 finds and accesses an entry in the cache 308 corresponding to the neighbor row, and reads, from the entry 408a, a stored counter value 412a corresponding to the neighbor row 208.

At step 510, the row hammer mitigation engine 116 determines that the counter value 412a satisfies a threshold value. In some embodiments, the threshold value is a predetermined refresh threshold.

At step 512, the row hammer mitigation engine 116 issues a refresh request based on the counter value 412a satisfying the threshold value. In some embodiments, the refresh request is sent to the memory controller 112 for the memory controller 112 to refresh the neighbor row 208.

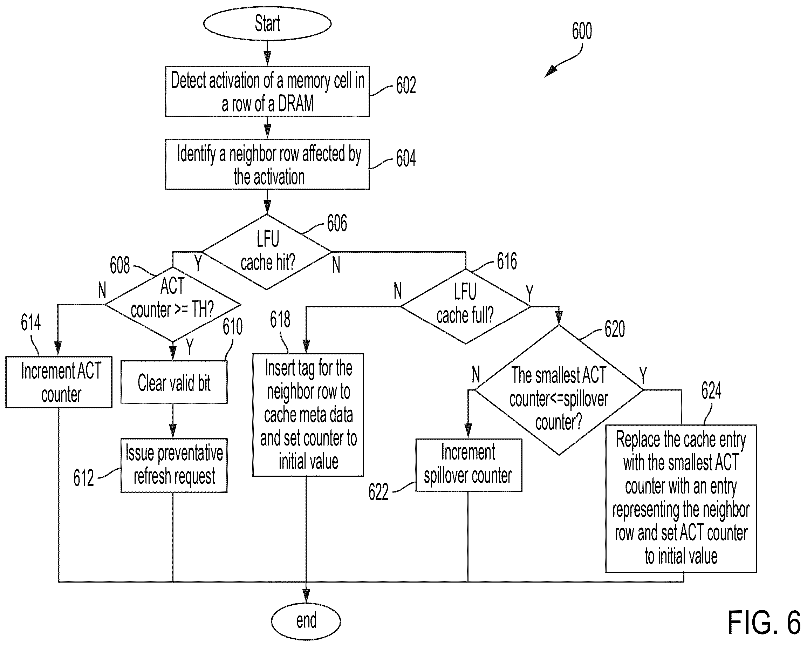

Fig. 6 depicts a flow diagram of a process 600 for mitigating effects of row hammer attacks, in accordance with one or more embodiments. In some embodiments, the process 600 starts, and at step 602, the memory controller 112 or mitigation engine 116 detects an activation (e.g., write operation) of a memory cell 204 in a DRAM row 206. In some embodiments, detection of the activation triggers a row hammer mitigation process and/or invokes the mitigation engine 116. In some embodiments, the row hammer mitigation process may be triggered and/or the mitigation engine 116 invoked based on various triggers. For example, in some embodiments, the detection may include receiving an activation request at the memory controller 112 from an application in the host device 110. The row hammer mitigation process may be triggered by the memory controller 112 or the mitigation engine 116. In some embodiments, the mitigation engine 116 may be a part of the memory controller 112. In some embodiments, any steps or actions said to performed by the mitigation engine 116 may be performed by the memory controller 112, and any steps or actions said to performed by the memory controller 112 may be performed by the mitigation engine 116.

At step 604, the mitigation engine 116 identifies a neighbor row (e.g., rows 208, 210, 212, 214) of the activated row 206 that may be affected by the activation. At step 606, the mitigation engine 114 checks the metadata 312 for the cache 308 and determines whether it results in a cache hit or cache miss. A cache hit indicates that the neighbor row affected by the activation is one of the rows being tracked in the cache.

If the row is being tracked in the cache 308 and the check results in a cache hit, the process 600 proceeds to step 608, in which the mitigation controller 302 checks whether the corresponding activation ("ACT") counter value (e.g., counter value 412a) satisfies (e.g., is at least as large as) a threshold value ("TH"). In some embodiments, the existing counter value is compared to the threshold value. In some embodiments, such as illustrated in decision step 608, the existing counter value is incremented and then compared to the threshold value. In some embodiments, the threshold value is based on the row hammer threshold and/or other specifications and/or tolerances of the memory device 104 and/or DRAM 114. The counter value may be incremented by any value (e.g., 1, 2, .5, 10, -1, -2) in response to a cache hit. In some embodiments, the counter may be implemented using techniques other than numerical values to keep track of the number of times the row has been affected by an activation, and incrementing the counter can include any change in status of the counter to represent a cache hit. Similarly, the threshold value may be implemented numerically or otherwise.

If the counter value does satisfy the threshold value, the process 600 proceeds to step 610. At step 610, a valid bit 414 for the cache entry associated with the neighbor row is cleared. At step 612, the mitigation engine 116 issues a preventative refresh request to the memory controller 112 to refresh the neighbor row. Steps 610 and 612 may be performed in reverse order, simultaneously, or overlappingly. In some embodiments, the cache entry associated with the neighbor row is evicted if a preventative refresh request is issued. The clearing of the valid bit 414 at step 610 provides indication that the cache line is empty.

If the counter value does not satisfy the threshold value, the process 600 proceeds to step 614. At step 614, the counter value is incremented.

At step 606, if the meta data check results in a cache miss due to the affected row not being tracked in the cache, the process 600 proceeds to step 616.

At step 616, the mitigation controller 302 checks whether the allotted number of entries in the cache is full. The allotted number of entries may be based on the predefined number of affected rows to be tracked in the cache 308. If the allotted number of entries in the cache is not full, the process 600 proceeds to step 618.

At step 618, the tag (e.g., the row identifier) for the neighbor row is inserted to the cache metadata, a corresponding counter value is set to an initial value, and a corresponding valid bit 414 is enabled. In some embodiment, the initial value may be any numerical value, such as 0 or 1. In some embodiment, the initial value may be set to any initial status depending on the implementation of the counter.

At step 616, If the allotted number of entries in the cache is full, the process 600 proceeds to step 620. At step 620, the mitigation controller 302 obtains the value of the spillover counter 304 and compares the value of the spill over counter 304 to the smallest counter value in the cache or cache metadata. In some embodiments, the spillover counter 304 may be stored in the cache 308 or external to the cache 308. In some embodiments, the spillover counter 304 keeps track of the number of times an activation affects a row that is not tracked in the cache 308. In some embodiments, the mitigation controller 302 finds the smallest counter value of the rows tracked in the cache and compares that value to the value of the spillover counter 304. The spillover counter value may be incremented by any value (e.g., 1, 2, .5, 10, -1, -2). In some embodiments, the spillover counter may be implemented using techniques other than numerical values, such that comparison can be made between the spillover counter value and the counters in the cache.

In some embodiments, if the value of the smallest counter in the cache 308 is smaller than or equal to spillover counter 304, the process proceeds to step 622, in which the spillover counter is incremented. Incrementing the spillover counter may include a numerical change or any other change to the status of the spillover counter. In some embodiments, at decision step 620, the process may proceed to step 622 if the status of the spillover counter satisfies a predetermined condition for proceeding to step 622 when compared to the status of the counters in the cache.

At step 620, if value of the spillover counter 304 is at least as large as the smallest counter value in the cache, the process proceeds to step 624. At step 624, mitigation controller 302 evicts the entry in the way or cache line with the smallest counter value, and replaces the entry with the tag (e.g., the row identifier) for the affected row, sets a corresponding counter value an initial value, and enables a corresponding valid bit. In some embodiments, at decision step 620, the process may proceed to step 624 if the status of the spillover counter satisfies a predetermined condition for proceeding to step 624 when compared to the status of the counters in the cache. In some embodiments, when an entry in a way or cache line is evicted from the cache, the corresponding row 202 in the DRAM is preventatively refreshed.

One or more embodiments of the present disclosure provides row hammer mitigation techniques in which an LFU cache can capture workload access patterns and reduce or prevent the effects of row hammer attacks such as bit-flips by tracking a bounded number of frequently affected row, and dynamically updating the rows that are tracked based on frequency. In some embodiments, the LFU cache may be implemented as an SRAM cache, providing an efficient and low-complexity solution.

One or more embodiments of the present disclosure may be implemented in one or more processors. The term processor may refer to one or more processors and/or one or more processing cores. The one or more processors may be hosted in a single device or distributed over multiple devices (e.g. over a cloud system). A processor may include, for example, application specific integrated circuits (ASICs), general purpose or special purpose central processing units (CPUs), digital signal processors (DSPs), graphics processing units (GPUs), and programmable logic devices such as field programmable gate arrays (FPGAs). In a processor, as used herein, each function is performed either by hardware configured, i.e., hard-wired, to perform that function, or by more general-purpose hardware, such as a CPU, configured to execute instructions stored in a non-transitory storage medium (e.g. memory). A processor may be fabricated on a single printed circuit board (PCB) or distributed over several interconnected PCBs. A processor may contain other processing circuits; for example, a processing circuit may include two processing circuits, an FPGA and a CPU, interconnected on a PCB.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section, without departing from the scope of the inventive concept.

The terminology used herein is for the purpose of describing particular embodiments only and is not intended to be limiting of the inventive concept. Also, unless explicitly stated, the embodiments described herein are not mutually exclusive. Aspects of the embodiments described herein may be combined in some implementations.

As used herein, the terms "substantially," "about," and similar terms are used as terms of approximation and not as terms of degree, and are intended to account for the inherent deviations in measured or calculated values that would be recognized by those of ordinary skill in the art.

As used herein, the singular forms "a" and "an" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the inventive concept refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

Although exemplary embodiments of systems and methods for row hammer mitigation have been specifically described and illustrated herein, many modifications and variations will be apparent to those skilled in the art. Accordingly, it is to be understood that systems and methods for row hammer mitigation constructed according to principles of this disclosure may be embodied other than as specifically described herein. The disclosure is also defined in the following claims, and equivalents thereof.

The systems and methods for row hammer mitigation may contain one or more combination of features set forth in the below statements.

Statement 1: A method, comprising: receiving a first request associated with a first row of a memory device; identifying a second row associated with the first row; identifying a first counter value associated with the second row; determining that the first counter value satisfies a threshold value; and issuing a refresh request for the second row based on the first counter value satisfying the threshold value.

Statement 2: The method of statement 1, comprising: changing a status of an item associated with the first row based on issuing the refresh request.

Statement 3: The method of statement 1 or 2, wherein the first counter value is stored in a first cache line of a cache, wherein the first cache line is associated with the second row.

Statement 4: The method of statement 3, wherein the cache includes a set of cache lines storing counter values associated with a set of rows of the memory device, wherein the cache lines in the set are represented in a tree structure wherein a parent node represents a cache line storing a higher counter value than a cache line of a child node.

Statement 5: The method of any of statement 1-4, comprising: receiving a second request associated with a third row of the memory device; identifying a fourth row associated with the third row; identifying a second counter value associated with the fourth row; determining that the second counter value is below the threshold value; and incrementing the second counter value.

Statement 6: The method of any of statement 1-5, comprising: receiving a second request associated with a third row of the memory device; identifying a fourth row associated with the third row; determining, based on a set of items in a cache, that the fourth row is associated with a second counter value; determining the set of items in the cache is below a threshold number of items; adding, to the set of items, an item representing the fourth row; and setting a counter value associated with the fourth row to an initial value.

Statement 7: The method of any of statement 1-6, comprising: receiving a second request associated with a third row of the memory device; identifying a fourth row associated with the third row; determining, based on a set of items in a cache, the fourth row is associated with a second counter value; determining the set of items in the cache satisfies a threshold number of items; determining, based on a set of counters associated with the set of items, that a counter in the set of counters is larger in value than the second counter value; and incrementing the second counter value.

Statement 8: The method of any of statement 1-7, comprising: receiving a second request associated with a third row of the memory device; identifying a fourth row associated with the third row; determining, based on a set of items in a cache, that the fourth row is associated with a second counter; determining that the set of items in the cache satisfies a threshold number of items; determining, based on a set of counters associated with the set of items, that a counter in the set of counters is larger in value than the second counter; changing a status of an item associated with the counter; adding, to the set of items, an item representing the fourth row; and setting a third counter associated with the fourth row to an initial value.

Statement 9: The method of statement 8, comprising: issuing a refresh request for a row of the memory device associated with the item associated with the counter.

Statement 10: The method of any of statement 1-9, wherein the second row is adjacent to the first row.

Statement 11: A device, comprising:
a processor; and a memory, wherein the memory stores instructions that, when executed by the processor, cause the processor to: receive a first request associated with a first row of a memory device; identify a second row associated with the first row;
identify a first counter value associated with the second row; determine that the first counter value satisfies a threshold value; and issue a refresh request for the second row based on the first counter value satisfying the threshold value.

Statement 12: The device of statement 11, wherein the instructions, when executed by the processor, further cause the processor to: receive a second request associated with a third row of the memory device; identify a fourth row associated with the third row; identify a second counter value associated with the fourth row; determine that the second counter value is below the threshold value; and increment the second counter value.

Statement 13: The device of statement 11 or 12, wherein the instructions, when executed by the processor, further cause the processor to: receive a second request associated with a third row of the memory device; identify a fourth row associated with the third row; determine, based on a set of items in a cache, that the fourth row is associated with a second counter value; determine the set of items in the cache is below a threshold number of items; add, to the set of items, an item representing the fourth row; and setting a counter value associated with the fourth row to an initial value.

Statement 14: The device of any of statement 11-13, wherein the instructions, when executed by the processor, further cause the processor to: receive a second request associated with a third row of the memory device; identify a fourth row associated with the third row; determine, based on a set of items in a cache, the fourth row is associated with a second counter value; determine the set of items in the cache satisfies a threshold number of items; determine, based on a set of counters associated with the set of items, that a counter in the set of counters is larger in value than the second counter value; and increment the second counter value.

Statement 15: The device of any of statement 11-14, wherein the instructions, when executed by the processor, further cause the processor to: receive a second request associated with a third row of the memory device; identify a fourth row associated with the third row; determine, based on a set of items in a cache, that the fourth row is associated with a second counter; determine that the set of items in the cache satisfies a threshold number of items; determine, based on a set of counters associated with the set of items, that a counter in the set of counters is larger in value than the second counter; change a status of an item associated with the counter; add, to the set of items, an item representing the fourth row; and set a third counter associated with the fourth row to an initial value.

Statement 16: A device, comprising: a processor; and a memory, wherein the memory stores instructions that, when executed by the processor, cause the processor to: detect activation of a first row of a memory device; identify a second row associated with the first row; identify a first counter value associated with the second row; determine that the first counter value satisfies a threshold value; and refresh the second row based on the first counter value satisfying the threshold value.

Statement 17: The device of statement 16, wherein the instructions, when executed by the processor, further cause the processor to: detect activation of a third row of the memory device; identify a fourth row associated with the third row; identify a second counter value associated with the fourth row; determine that the second counter value is below the threshold value; and increment the second counter value.

Statement 18: The device of statement 16 or 17, wherein the instructions, when executed by the processor, further cause the processor to: detect activation of a third row of the memory device; identify a fourth row associated with the third row; determine, based on a set of items in a cache, that the fourth row is associated with a second counter value; determine the set of items in the cache is below a threshold number of items; add, to the set of items, an item representing the fourth row; and set a counter value associated with the fourth row to an initial value.

Statement 19: The device of any of statement 16-18, wherein the instructions, when executed by the processor, further cause the processor to: detect activation of a third row of the memory device; identify a fourth row associated with the third row; determine, based on a set of items in a cache, the fourth row is associated with a second counter value; determine the set of items in the cache satisfies a threshold number of items; determine, based on a set of counters associated with the set of items, that a counter in the set of counters is larger in value than the second counter value; and increment the second counter value.

Statement 20: The device of any of statement 16-19, wherein the instructions, when executed by the processor, further cause the processor to: detect activation of a third row of the memory device; identify a fourth row associated with the third row; determine, based on a set of items in a cache, that the fourth row is associated with a second counter; determine that the set of items in the cache satisfies a threshold number of items; determine, based on a set of counters associated with the set of items, that a counter in the set of counters is larger in value than the second counter; change a status of an item associated with the counter; add, to the set of items, an item representing the fourth row; and set a third counter associated with the fourth row to an initial value.

## Claims

1. A method, comprising:
receiving a first request associated with a first row of a memory device;
identifying a second row associated with the first row;
identifying a first counter value associated with the second row;
determining that the first counter value satisfies a threshold value; and
issuing a refresh request for the second row based on the first counter value satisfying the threshold value.

2. The method of claim 1, comprising:
changing a status of an item associated with the first row based on issuing the refresh request.

3. The method of claim 1 or 2, wherein the first counter value is stored in a first cache line of a cache, wherein the first cache line is associated with the second row.

4. The method of claim 3, wherein the cache includes a set of cache lines storing counter values associated with a set of rows of the memory device, wherein the cache lines in the set are represented in a tree structure wherein a parent node represents a cache line storing a higher counter value than a cache line of a child node.

5. The method of any one of claims 1 to 4, comprising:
receiving a second request associated with a third row of the memory device;
identifying a fourth row associated with the third row;
identifying a second counter value associated with the fourth row;
determining that the second counter value is below the threshold value; and
incrementing the second counter value.

6. The method of any one of claims 1 to 4, comprising:
receiving a second request associated with a third row of the memory device;
identifying a fourth row associated with the third row;
determining, based on a set of items in a cache, that the fourth row is associated with a second counter value;
determining the set of items in the cache is below a threshold number of items;
adding, to the set of items, an item representing the fourth row; and
setting a counter value associated with the fourth row to an initial value.

7. The method of any one of claims 1 to 4, comprising:
receiving a second request associated with a third row of the memory device;
identifying a fourth row associated with the third row;
determining, based on a set of items in a cache, the fourth row is associated with a second counter value;
determining the set of items in the cache satisfies a threshold number of items;
determining, based on a set of counters associated with the set of items, that a counter in the set of counters is larger in value than the second counter value; and
incrementing the second counter value.

8. The method of any one of claims 1 to 4, comprising:
receiving a second request associated with a third row of the memory device;
identifying a fourth row associated with the third row;
determining, based on a set of items in a cache, that the fourth row is associated with a second counter;
determining that the set of items in the cache satisfies a threshold number of items;
determining, based on a set of counters associated with the set of items, that a counter in the set of counters is larger in value than the second counter;
changing a status of an item associated with the counter;
adding, to the set of items, an item representing the fourth row; and
setting a third counter associated with the fourth row to an initial value.

9. The method of claim 8, comprising:
issuing a refresh request for a row of the memory device associated with the item associated with the counter.

10. The method of any one of claims 1 to 9, wherein the second row is adjacent to the first row.

11. A device, comprising:
a processor; and
a memory, wherein the memory stores instructions that, when executed by the processor, cause the processor to perform the method according to any one of the preceding claims.
